# EUROPÄISCHE PATENTANMELDUNG

(11) **EP 1 487 027 A2**
(43) Veröffentlichungstag der Anmeldung: **15.12.2004**
(21) Anmeldenummer: 04090226.4
(22) Anmeldetag: 10.06.2004
(51) Int. Cl.: H01L 51/20

(54) **OLED-Bauelement und Display auf Basis von OLED-Bauelement mit verbesserter Effizienz**

(30) Priorität: 10.06.2003 DE 10326725
(71) Anmelder: Samsung SDI Co., Ltd., Suwon-si, Gyeonggi-do (KR)
(72) Erfinder: Uhlig, Albrecht, 12524 Berlin (DE); Schrader, Thomas, 12557 Berlin (DE)
(74) Vertreter: Hengelhaupt, Jürgen, Dipl.-Ing.

(57) **Zusammenfassung**

Die Erfindung betrifft ein OLED-Bauelement und ein Display auf Basis von OLED-Bauelementen gemäß den Oberbegriffen der Ansprüche 1, 16 und 17.

Es ist Aufgabe der vorliegenden Erfindung, ein OLED-Bauelement sowie ein Display auf Basis von OLED-Bauelementen mit einer höheren Effizienz im Vergleich zu den OLED-Bauelementen bzw. Displays auf Basis von OLED-Bauelementen nach dem Stand der Technik anzugeben. Hierdurch soll die Energieaufnahme des OLED-Bauelementes bzw. des Displays gesenkt werden.

Dadurch, dass zwischen Anode (2) und organischem Emitter-Material (5) eine Löcherblockierschicht (4) angeordnet wird, kann die Effizienz eines OLED-Bauelementes, vorzugsweise eines OLED-Bauelementes auf polymerer Basis, überraschenderweise signifikant erhöht werden.

## Beschreibung

Die Erfindung betrifft ein OLED-Bauelement und ein Display auf Basis von OLED-Bauelementen gemäß den Oberbegriffen der Ansprüche 1, 16 und 17.

Das Grundprinzip, welches den OLED Bauelementen (organic light emitting device) zugrunde liegt, ist die Elektrolumineszenz. Hier werden durch geeignete Kontakte Elektronen und Defektelektronen (Löcher) in ein halbleitendes Material injiziert. Bei der Rekombination treffen ein Elektron und ein Defektelektron aufeinander und es entsteht ein elektrisch neutrales, aber angeregtes Molekül, welches, z.B. aus der Materialklasse der Polyfluorene stammend, unter Lichtaussendung in seinen Grundzustand zurückkehrt. Als organische Emittermaterialien sind verschiedene, organische Verbindungen bekannt, welche sich in niedermolekulare und polymere organische Verbindungen unterteilen lassen.

Ein OLED Bauelement muss für einen effizienten Betrieb verschiedene Eigenschaften, wie z. B. Elektronen-, Lochleitung und Lichtemission, aufweisen. Dabei wird die Effizienz durch das Verhältnis von ausgesendetem Licht pro injiziertem Ladungsträger definiert. Die meisten der verwendeten Materialien erfüllen nur eine der vorgenannten Eigenschaften (Elektronen-, Lochleitung, Lichtemission) in befriedigendem Maße. Zur Verbesserung der Effizienz ist es daher bekannt, Vielschichtbauelemente zu verwenden, in denen unterschiedliche Schichten kombiniert werden. So besitzt beispielsweise eine Schicht eine herausragende Funktion bzgl. der Lochleitung, während eine andere Schicht die Funktion der Elektronenleitung besser erfüllt. Diese unterschiedlichen Schichten werden im OLED Bauelement in einer bestimmten, der Energieeffizienz des Bauelementes zuträglichen Weise angeordnet.
Der Einsatz spezieller Schichten zur Erhöhung der Effizienz von OLED Bauelementen ist aus den unterschiedlichsten Veröffentlichungen bekannt.

WO 02/091814 A2 beschreibt eine phosphoreszierende, Licht emittierende Struktur aus niedermolekularem organischen Emittermaterial mit einer Vielzahl von Dotierungen, wobei mindestens eine der Dotierungen ein phosphoreszierendes Material ist. Durch den Einsatz von zwischen Anode und dotiertem Emitter angeordneter Lochblockierschicht und Lochtransportschicht soll eine vermehrte Rekombination von Elektronen und Defektelektronen zu Exitonen im Bereich zwischen Lochblockierschicht und Lochtransportschicht erreicht werden. Nachteilhafterweise ist diese Anwendung auf dotierte Small Molecule Emittermaterialien beschränkt, da beispielsweise die Lebensdauer der Exitonen für eine Anregung undotierten, polymeren Emittermaterials bei Verschiebung der Rekombinationszone aus dem Emittermaterial heraus nicht ausreicht. Weiterhin würde die Notwendigkeit, dass die Lochblockierschicht für Exitonen durchlässig ist, zu einer starken Beschränkung in der Materialauswahl führen.

WO2003001569 A2 (Princeton University) beschreibt eine OLED mit einem Aufbau Anode/ polymere Lochtransport- und lichtemittierende Schicht/ Small Molecule (kurzkettige Moleküle) Exiton blockierende Schicht/ Small Molecule Elektronenleitende Schicht/ Kathode. Dabei wird Polyvinylkarbazol (PVK) als Lochleiter verwendet. Die PVK-Schicht ist dotiert mit im grünen, roten bzw. blauen Spektralbereich lichtemittierenden Farbstoffen, um ein Vollfarbenanzeigeelement zu erhalten. Weiterhin ist der Einsatz einer exitonenblockierenden Schicht beschrieben, welche aus kurzkettigen Molekülen besteht und zwischen der PVK-Schicht und der Kathode angeordnet ist.

US 20020089282 A1 (KIJIMA, YASUNORI; TAMURA, SHINICHIRO) beschreibt eine Struktur eines Anzeigeelementes, in welcher eine rotfarbene, grünfarbene und blaufarbene Lichtemission in drei benachbarten Pixelelementen erzeugt wird. Dabei weist das Anzeigeelement die Struktur transparente Anode/lochleitende und blau emittierende Schicht/lochblockierende Schicht/Elektronen leitende und grün oder rot emittierende Schicht/transparente Kathode auf. Die lochblockierende Schicht besteht aus Phenantrolin Derivaten. Der Effekt der lochblockierenden Schicht für den Fall der blauen Emission besteht darin, daß die Migration von Löchern in die elektronenleitende Schicht unterdrückt wird. Somit wird die Rekombination von Löchern und Elektronen in der Blau emittierenden Schicht und damit die Erzeugung von blauem Licht bevorzugt.
US 6291116 B1 (3M) beschreibt den Einsatz einer Lasertransfer Technologie (LITI) zur Erzeugung eines Vollfarben OLED Bauelementes der Struktur Anode/ lochleitende Schicht/lichtemittierende Schicht/ elektronenleitende Schicht/Kathode. Weiterhin ist eine lochblockierende Schicht vorgesehen, welche zwischen lichtemittierender Schicht und der Kathode angeordnet ist. Die Funktion der lochblockierenden Schicht besteht darin, die Migration von Löchern zur Kathode zu unterdrücken.

Nachteilig an den vorgenannten OLED Bauelementen nach dem Stand der Technik ist jedoch deren niedrige Effizienz, welche zu einer (unerwünscht) hohen Energieaufnahme bei vorgegebener Helligkeit des OLED Bauelements führt.

Es ist daher Aufgabe der vorliegenden Erfindung, ein OLED-Bauelement auf polymerer Basis sowie ein Display auf Basis von OLED-Bauelementen auf polymerer Basis mit einer höheren Effizienz im Vergleich zu OLED-Bauelementen bzw. Displays auf Basis von OLED-Bauelementen nach dem Stand der Technik anzugeben. Hierdurch soll die Energieaufnahme des OLED-Bauelementes bzw. des Displays gesenkt werden.

Diese Aufgabe wird erfindungsgemäß gelöst durch die Merkmale im kennzeichnenden Teil des Anspruchs 1 (OLED-Bauelement), des Anspruchs 16 (Display) sowie des Anspruchs 17 (Verfahrensanspruch) im Zusammenwirken mit den Merkmalen im Oberbegriff. Zweckmäßige Ausgestaltungen der Erfindung sind in den Unteransprüchen enthalten.

Dadurch, dass zwischen Anode und organischem Emitter-Material auf polymerer Basis eine Löcherblockierschicht angeordnet wird, kann die Effizienz eines OLED-Bauelementes auf polymerer Basis überraschenderweise signifikant erhöht werden. Überraschender Weise ist bei OLED-Bauelementen auf polymerer Basis die Anzahl der injizierten Defektelektronen (Löcher) in der Regel deutlich größer als die der injizierten Elektronen. Da für die Elektrolumineszenz jeweils genau ein Elektron und genau ein Defektelektron benötigt wird, ist eine hohe Effizienz eines OLED-Bauelementes nur bei einer nahezu gleichen Anzahl von Elektronen und Defektelektronen möglich. Die Löcherblockierschicht hat dabei den Zweck, die Anzahl der Defektelektronen im Emittermaterial zu verringern und damit der Anzahl der Elektronen anzugleichen. Das organische, polymere Emittermaterial ist vorzugsweise undotiertes Emittermaterial.
Die Löcherblockierschicht besteht vorzugsweise aus Tris-(5-chloro-8-hydroxy-quinolinato)-aluminium (AlQ₃), Bis-(2-methyl-8-quinolinolato)4-(phenyl-phenolato)-aluminium (BALQ₃), 4,4-Bis(2,2-diphenyl-ethen-1-yl)-biphenyl (DPVBi) oder Spiro-DPVBi.

In einer bevorzugten Ausführungsvariante ist die energetische Lage des höchsten besetzten Molekülorbitals (Valenzband) der Löcherblockierschicht betragsmäßig mindestens 0,1 eV größer als die energetische Lage des höchstens besetzten Molekülorbitals (Valenzband) des organischen Emittermaterials. Da die Energien der Elektronen grundsätzlich negative Werte besitzen, ist die betragsmäßig energetisch höhere Lage des Valenzbandes der Löcherblockierschicht tatsächlich niedriger als die energetische Lage des Valenzbandes des organischen Emittermaterials.

In einer besonders bevorzugten Ausführungsvariante ist es erfindungsgemäß vorgesehen, dass das OLED-Bauelement eine Lochtransportschicht aufweist, welche zwischen Anode und der Löcherblockierschicht oder zwischen der Löcherblockierschicht und dem organischen Emittermaterial angeordnet ist. Die Lochtransportschicht besteht vorzugsweise aus Polyethylendioxythiophen-Polysterolsulfonsäure.

Die Kathode besteht vorzugsweise aus Aluminium, Silber Ytterbium und/oder Calcium und die Anode besteht vorzugsweise aus Indium-Zinnoxid (ITO). In einer besonders bevorzugten Ausgestaltung der Erfindung besteht die Kathode aus Aluminium/Calcium oder Aluminium/Calcium/Lithiumfluorid.
Das organische Emittermaterial stammt vorzugsweise aus den Materialklassen der Polyphenylenvinylene oder Polyfluorene. Die Lochtransportschicht weist vorzugsweise eine Dicke zwischen 30 und 150 nm, die Löcherblockierschicht vorzugsweise eine Dicke zwischen 1 und 50 nm und das organische Emittermaterials weist vorzugsweise eine Dicke zwischen 50 und 120 nm auf.

Durch die zwischen Kathode und Emittermaterial angeordnete erfindungsgemäße Löcherblockierschicht wird die Anzahl der Defektelektronen (Löcher) derart reduziert, dass die Anzahl von Elektronen und Defektelektronen gleich bzw. nahezu gleich ist. Hierdurch wird eine unnötig hohe Injektion von Defektelektronen in das OLED-Bauelement und eine damit einhergehende (unnötig) hohe Leistungsaufnahme vermieden. Hierdurch kann die Effizienz des erfindungsgemäßen OLED-Bauelementes erhöht werden.
Ein erfindungsgemäßes Display auf Basis organischer Leuchtdioden (OLED) ist durch mindestens ein erfindungsgemäßes OLED-Bauelement gekennzeichnet.

Das erfindungsgemäße Verfahren zur Erzeugung von Elektrolumineszenzlicht weist folgende Verfahrensschritte auf:
- Injektion von Elektronen über eine Kathode in organisches, polymeres Emittermaterial durch Anlegen eines elektrischen Feldes
- Injektion von Defektelektronen über eine Anode in organisches, polymeres Emittermaterial durch Anlegen eines elektrischen Feldes,
wobei die durch das anliegende elektrische Feld hervorgerufene Bewegung der Defektelektronen von der Anode zum polymeren Emittermaterial reduziert und/oder zumindest teilweise unterdrückt wird.

Vorzugsweise wird die Bewegung eines Teil der sich von der Anode zum polymeren Emittermaterial wandernden Defektelektronen unterdrückt. In einer besonders bevorzugten Ausführungsvariante des erfindungsgemäßen Verfahrens wird die Anzahl der sich von der Anode zum polymeren Emittermaterial bewegenden Defektelektronen derart reduziert, dass die Anzahl der in das polymere Emittermaterial injizierten Defektelektronen der Anzahl der in das polymere Emittermaterial injizierten Elektronen entspricht oder nahezu entspricht.

Die Erfindung wird nachstehend anhand von Ausführungsbeispielen näher erläutert.
Es zeigen:
- Figur 1:: ein erfindungsgemäßes OLED-Bauelement in schematischer, geschnittener Darstellung mit einer zwischen Anode und Löcherblockierschicht angeordneten Lochtransportschicht,
- Figur 2:: ein erfindungsgemäßes OLED-Bauelement in schematischer, geschnittener Darstellung mit einer zwischen Löcherblockierschicht und organischem Emittermaterial angeordneten Lochtransportschicht und
- Figur 3:: Effizienz-Spannungs-Kennlinie für ein OLED-Bauelement ohne Löcherblockierschicht und ein OLED-Bauelement mit erfindungsgemäßer Löcherblockierschicht.

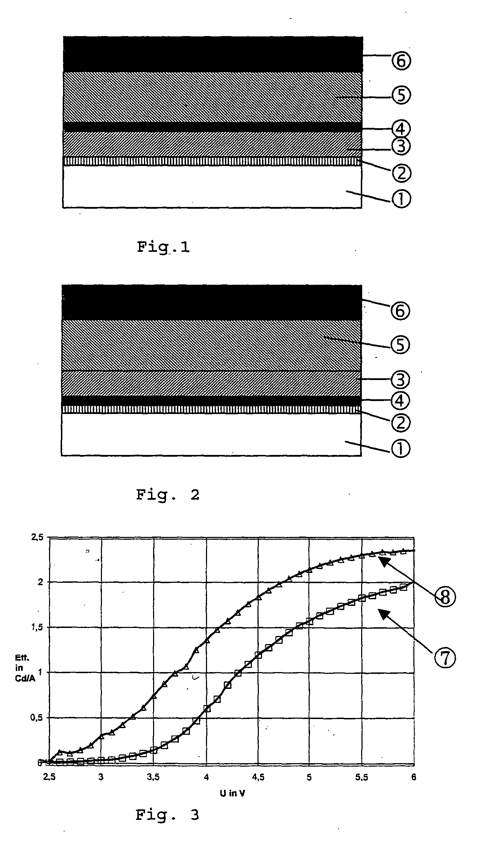

Figur 1 zeigt ein erfindungsgemäßes OLED-Bauelement, bestehend aus einem Substrat 1, einer darüber angeordneten Anode 2, einer darauf angeordneten Lochtransportschicht 3, einer darauf angeordneten Löcherblockierschicht 4, darauf angeordnetem organischem Emittermaterial 5 und einer darüber angeordneten Kathode 6. Das erfindungsgemäße OLED-Bauelement wird auf dem Glassubstrat 1 aufgebaut, welches mit einer transparenten, leitfähigen Anodenschicht 2 aus Indium-Zinnoxid (ITO) beschichtet ist. Auf die ITO-Schicht (Anode 2) wird durch Aufschleudern eine Lochtransportschicht 3 aufgebracht. Diese besteht aus Polyethylendioxithiophen-Polysterolsulfonsäure. Die typische Schichtdicke liegt im Bereich von 30 bis 150 nm. Auf die Lochtransportschicht 3 wird durch thermisches Verdampfen im Hochvakuum eine Löcherblockierschicht 4 aufgebracht. Geeignete Materialklassen umfassen niedermolekulare Metallkomplexverbindungen, wie AlQ₃ oder BALQ₃ oder niedermolekulare diphenyle Verbindungen wie 4,4-Bis(2,2-diphenylethen-1-yl)-biphenyl (DPVBI) oder niedermolekulare Spiro-Verbindungen wie Spiro-DPVBi. Bevorzugte Schichtdicken liegen im Bereich von 1 bis 50nm, insbesondere im Bereich von 5 nm bis 15 nm. Alternativ kann als Verfahren zur Schichtbildung auch das nasschemische Schleudern oder Drucken angewendet werden.

Auf die Löcherblockierschicht 4 wird ebenfalls durch Aufschleudern aus der Lösung ein Emitterpolymer 5 aufgebracht. Das Emitterpolymer 5 stammt bevorzugt aus den Materialklassen der Polyphenylenvinylene und sowie der Polyfluorene. Bevorzugte Schichtdicken liegen im Bereich von 50 bis 120 nm.

Zur Verbesserung der elektrischen Eigenschaften wird vorzugsweise eine dünne Zwischenschicht aus Alkali oder Erdalkalifluoriden, vorzugsweise Lithiumfluorid zwischen dem organischen Material 5 und der Kathode 6 eingebracht. Dies geschieht durch thermisches Verdampfen.

Die aktive Struktur wird abgeschlossen durch einen reflektiven Metallkontakt (Kathode 6), welcher ebenfalls durch thermisches Verdampfen im Hochvakuum abgeschieden wird. Geeignete Metalle sind Aluminium, Silber, Ytterbium und Calcium. In einer besonders bevorzugten Ausgestaltung ist die Kathode 6 aus Aluminium, Alumunium/Calcium oder Aluminium/Calcium/Lithiumfluorid ausgebildet. Die so erzeugte Struktur wird nachfolgend durch eine (hier nicht dargestellte) Glasverkapselung gegen Umwelteinflüsse geschützt.

Alternativ ist es zum vorgenannten Ausführungsbeispiel möglich, die Löcherblockierschicht 4 direkt auf die transparente, leitfähige Schicht (Anode 2) durch thermisches Verdampfen aufzubringen, wie in Figur 2 schematisch dargestellt ist. Die Lochtransportschicht 3 wird dann auf die Löcherblockierschicht 4 durch Spincoating/Aufschleudern aufgebracht. Danach werden, wie bereits im vorhergehenden Ausführungsbeispiel beschrieben, das organische Emittermaterial 5 und die Kathode 6 aufgebracht.

Wie den Ausführungsbeispielen nach den Figuren 1 und 2 zu entnehmen ist, ist es für eine Steigerung der Effizienz des OLED des erfindungsgemäßen OLED-Bauelementes unerheblich, ob die Löcherblockierschicht 4 zwischen Anode 2 und Lochtransportschicht 3 oder zwischen Lochtransportschicht 3 und organischem Emittermaterial 5 angeordnet ist.

Wie in Figur 3 schematisch dargestellt ist, steigt die Bauelementeeffizienz eines erfindungsgemäßen OLED-Bauelementes (siehe Effizienz-Spannungs-Kennlinie 8) gegenüber einem OLED-Bauelement ohne Löcherblockierschicht nach dem Stand der Technik (siehe Effizienz-Spannungs-Kennlinie 7) bei gleicher angelegter Spannung früher an.

Dabei besteht das OLED-Bauelement ohne Löcherblockierschicht nach dem Stand der Technik (siehe Effizienz-Spannungs-Kennlinie 7) aus dem Schichtaufbau Anode 2 (Indium-Zinnoxid)/ Lochtransportschicht 3 (50 nm PEDT)/ organisches Emittermaterial 5 (80 nm BP79) / 1 nm LiF/ Kathode 6 (10 nm Calcium und 500 nm Aluminium). Dabei handelt es sich bei PEDT um Polyethylen - Dioxythiophen/Polystyren Sulfonat, welches unter den Markennamen Baytron P VP CH 8000 (Hersteller H.C. Stark) erhältlich ist. BP79 ist ein auf einer Polyfluoren-Grundstruktur basierendes emittierendes Polymer. Im Gegensatz dazu besteht das erfindungsgemäße OLED-Bauelement mit Löcherblockierschicht (siehe Effizienz-Spannungs-Kennlinie 8) aus dem Schichtaufbau Anode 2 (Indium-Zinnoxid)/ Lochtransportschicht 3 (50 nm PEDT)/ Löcherblockierschicht (10 nm AlQ₃)/ organisches Emittermaterial 5 (80 nm BP79)/ 1 nm LiF/ Kathode 6 (10 nm Calcium und 500 nm Aluminium).

Weiterhin ist die maximal erreichbare Effizienz des (erfindungsgemäßen) OLED-Bauelementes deutlich erhöht. Diese beiden Effekte senken die Leistungsaufnahme des erfindungsgemäßen OLED-Bauelementes bzw. eines erfindungsgemäßen Displays, welches mindestens ein erfindungsgemäßes OLED-Bauelement aufweist.

Die Erfindung ist nicht beschränkt auf die hier dargestellten Ausführungsbeispiele, vielmehr ist es möglich, durch Kombination und Modifikation der genannten Mittel und Merkmale weitere Ausführungsvarianten zu realisieren, ohne den Rahmen der Erfindung zu verlassen.

### Bezugszeichenliste

- 1: Substrat
- 2: Anode
- 3: Lochtransportschicht
- 4: Löcherblockierschicht
- 5: organisches Emittermaterial
- 6: Kathode
- 7: Effizienz-Spannungs-Kennlinie eines OLED-Bauelementes ohne Löcherblockierschicht (Stand der Technik)
- 8: Effizienz-Spannungs-Kennlinie eines (erfindungsgemäßen) OLED-Bauelementes mit Löcherblockierschicht

## Patentansprüche

1. OLED-Bauelement aufweisend ein Substrat (1), eine Anode (2), organisches Emittermaterial (5) auf polymerer Basis und eine Kathode (6), **dadurch gekennzeichnet, dass** zwischen Anode (2) und organischem Emittermaterial (5) eine Löcherblockierschicht (4) angeordnet ist.

2. Bauelement nach Anspruch 1, **dadurch gekennzeichnet, dass** die Löcherblockierschicht (4) aus Tris-(5-chloro-8-hydroxy-quinolinato)-aluminium (AlQ₃), Bis-(2-methyl-8-quinolinolato)4-(phenyl-phenolato)-aluminium (BALQ₃), 4,4-Bis(2,2-diphenyl-ethen-1-yl)-biphenyl (DPVBi) oder Spiro-DPVBi besteht.

3. Bauelement nach Anspruch 1 oder 2, **dadurch gekennzeichnet, dass** die energetische Lage des höchsten besetzen Molekülorbitals (Valenzband) der Löcherblockierschicht (4) betragsmäßig mindestens 0,1 eV größer als die energetische Lage des höchsten besetzen Molekülorbitals (Valenzband) des organischen Emittermaterials (5) ist.

4. Bauelement nach einem der vorhergehenden Ansprüche, **dadurch gekennzeichnet, dass** die Kathode (6) aus Aluminium, Silber, Ytterbium und/oder Calcium und die Anode (2) aus Indium-Zinnoxid (ITO) besteht.

5. Bauelement nach einem der vorhergehenden Ansprüche, **dadurch gekennzeichnet, dass** das Bauelement mindestens Lochtransportschicht (3) aufweist.

6. Bauelement nach Anspruch 5, **dadurch gekennzeichnet, dass** die Lochtransportschicht (3) aus Poly(Ethylendioxythiophen)-Polystyrolsulfonsäure besteht.

7. Bauelement nach Anspruch 5 oder 6, **dadurch gekennzeichnet, dass** die Lochtransportschicht (3) eine Dicke zwischen 30 nm und 150 nm aufweist.

8. Bauelement nach einem der Ansprüche 5 bis 7, **dadurch gekennzeichnet, dass** die Lochtransportschicht (3) zwischen der Anode (2) und der Löcherblockierschicht (4) oder zwischen der Löcherblockierschicht (4) und dem organischen Emittermaterial (5) angeordnet ist.

9. Bauelement nach einem der vorhergehenden Ansprüche, **dadurch gekennzeichnet, dass** das organischen Emittermaterial (5) aus den Materialklassen der Poly(phenylenvinylen)e oder der Polyfluorene ausgewählt ist.

10. Bauelement nach einem der vorhergehenden Ansprüche, **dadurch gekennzeichnet, dass** das organischen Emittermaterial (5) eine Schichtdicke zwischen 50 nm und 120 nm aufweist.

11. Bauelement nach einem der vorhergehenden Ansprüche, **dadurch gekennzeichnet, dass** zwischen organischem Emittermaterial (5) und Kathode (6) eine Schicht eines Alkali- oder Erdalkalifluorids angeordnet ist.

12. Bauelement nach Anspruch 11, **dadurch gekennzeichnet, dass** die Schicht eines Alkali- oder Erdalkalifluorids zumindest teilweise die Kathode (6) ausbildet.

13. Bauelement nach Anspruch 11 oder 12, **dadurch gekennzeichnet, dass** das Alkalifluorid Lithiumfluorid ist.

14. Bauelement nach einem der vorhergehenden Ansprüche, **dadurch gekennzeichnet, dass** die Löcherblockierschicht (4) eine Dicke zwischen 1 nm und 50 nm aufweist.

15. Bauelement nach einem der vorhergehenden Ansprüche, **dadurch gekennzeichnet, dass** das Bauelement eine Verkapselung aufweist.

16. Display auf Basis organischer Leuchtdioden **gekennzeichnet durch** mindestens ein Bauelement nach einem der Ansprüche 1 bis 15.

17. Verfahren zur Erzeugung von Elektrolumineszenzlicht durch Injektion von Elektronen über eine Kathode in organisches, polymeres Emittermaterial durch Anlegen eines elektrischen Feldes, Injektion von Defektelektronen über eine Anode in organisches, polymeres Emittermaterial durch Anlegen eines elektrischen Feldes,
**dadurch gekennzeichnet, dass**
die durch das anliegende elektrische Feld hervorgerufene Bewegung der Defektelektronen von der Anode zum polymeren Emittermaterial reduziert und/oder zumindest teilweise unterdrückt wird.

18. Verfahren nach Anspruch 17,
**dadurch gekennzeichnet, dass**
die Anzahl der sich von der Anode zum polymeren Emittermaterial bewegenden Defektelektronen derart reduziert wird, dass die Anzahl der in das polymere Emittermaterial injizierten Defektelektronen der Anzahl der in das polymere Emittermaterial injizierten Elektronen entspricht oder nahezu entspricht.
